# EUROPÄISCHE PATENTSCHRIFT

(11) **EP 3 977 830 B1**
(45) Veröffentlichungstag und Bekanntmachung des Hinweises auf die Patenterteilung: **14.01.2026**
(21) Anmeldenummer: 20730377.7
(22) Anmeldetag: 04.05.2020
(51) Int. Cl.: H05K 7/20

(54) **LEISTUNGSELEKTRONIKEINHEIT MIT ZUMINDEST EINEM MITTELS EINER KUNSTSTOFFHALTERUNG ANGEBUNDENEN HALBLEITERMODUL**
POWER ELECTRONICS UNIT HAVING AT LEAST ONE SEMICONDUCTOR MODULE ATTACHED BY MEANS OF A PLASTIC HOLDER
UNITÉ D'ÉLECTRONIQUE DE PUISSANCE COMPRENANT AU MOINS UN MODULE SEMI-CONDUCTEUR RACCORDÉ AU MOYEN D'UN SUPPORT EN MATIÈRE SYNTHÉTIQUE

(30) Priorität: 24.05.2019 DE 102019114001
(43) Veröffentlichungstag der Anmeldung: 06.04.2022
(73) Patentinhaber: Schaeffler Technologies AG & Co. KG, 91074 Herzogenaurach (DE)
(72) Erfinder: MÜLLER, Gregor, 77815 Bühl (DE)
(74) Vertreter: Schaeffler Technologies
(86) Internationale Anmeldenummer: PCT/DE2020/100368
(87) Internationale Veröffentlichungsnummer: WO 2020/239167

(56) Entgegenhaltungen:
- DE-A1- 102007 056 750
- DE-A1- 102012 203 634
- DE-B3- 102012 213 573
- US-A1- 2010 127 371

## Beschreibung

Die Erfindung betrifft eine Leistungselektronikeinheit für einen Elektromotor eines Kraftfahrzeugantriebs, d. h. eines vorzugsweise in einem Kraftfahrzeugantriebsstrang vorgesehenen Elektromotors, gemäß dem Oberbegriff des Anspruchs 1.

Im E-Mobilitätsbereich sind Leistungshalbleiter in der Regel direkt flüssigkeitsgekühlt, wobei neben einer möglichst idealen Anströmung durch das Kühlmedium auch die Dichtigkeit der Leistungshalbleitermodule gewährleistet sein soll. Auf der einen Seite sind die Halbleiter auf typische Weise an die beiden DC-Kontakte, auf der anderen Seite an den AC-Ausgang zum Elektromotor angeschlossen. Über so genannte Hilfskontakte sind die Leistungshalbleiter an eine Treiberplatine (Gate-Treiberplatine) angeschlossen, welche die Halbleiter je nach Drehmoment und Drehzahlvorgaben des Kraftfahrzeuges ansteuert. Gleichzeitig ist eine Vibrationsfestigkeit der elektrischen Komponenten sicherzustellen. Entsprechend sind somit ausreichende Steifigkeiten sowie Möglichkeiten zur gezielten Dämpfung von Frequenzen, wie sie im Automobilbereich durch Anregungen des Verbrennungsmotors bei Hybriden sowie durch die Straße auftreten, zu berücksichtigen. Werden kraftschlüssige Befestigungselemente zum Fixieren der Leistungshalbleiter an den Kühlkörper verwendet, unterliegen die statischen Dichtungen einer relativ hohen axialen Verpressung. Alternativ hierzu ist es prinzipiell möglich, Klemmsteine zu verwenden, wobei an den Leistungshalbleitern keine Löcher zur Verschraubung vorgesehen sind und die Leistungshalbleiter durch die Klemmsteine an die Kühlplatte angedrückt werden. Die Klemmsteine werden dann wiederum direkt verschraubt.

Es besteht weiterhin die Anforderung, eine hohe spezifische Leistung in Bezug auf das vorhandene Volumen / den Bauraum der Leistungselektronik zu erzielen. Die Leistungselektronik sollte möglichst kompakt aufgebaut sein. Gleichzeitig ist es notwendig gewisse Isolationsvorgaben, wie Luft- und Kriechstrecken, einzuhalten. Eine weitere Vorgabe ist, die elektrische Kontaktierung im HV- sowie LV-Bereich einfach zu montieren und die Verbindungen einfach konstruierbar zu machen. Zugleich ist die Vibrationsfestigkeit der Leistungselektronik zu gewährleisten.

Eine Leistungselektronikeinheit gemäß dem Oberbegriff des Anspruchs 1 ist aus jeder der DE 10 2012 203634 A1 und der US 2010/127371 A1 bekannt.

Bezüglich weiteren Standes der Technik wird auf die DE 10 2007 056750 A1 und die DE 10 2012 213573 B3 verwiesen.

Es ist daher Aufgabe der vorliegenden Erfindung, eine mit zumindest einem Halbleitermodul ausgestattete, kompakte sowie fest montierte Leistungselektronikeinheit zur Verfügung zu stellen, die eine einfachere Montage ermöglicht.

Dies wird erfindungsgemäß durch den Gegenstand des Anspruchs 1 gelöst. Demnach ist eine Leistungselektronikeinheit für einen Elektromotor eines Kraftfahrzeugantriebs, mit einem plattenförmigen Kühlkörper, zumindest einem Halbleitermodul sowie einem aus einem Kunststoff bestehenden, das zumindest eine Halbleitermodul relativ zu dem Kühlkörper festlegenden Modulhalter ausgestattet, wobei der Modulhalter über eine formschlüssige Schnappverbindung an dem Kühlkörper fixiert ist.

Durch diese formschlüssige Schnappverbindung zwischen dem Modulhalter und dem Kühlkörper werden die Halbleitermodule während der Montage auf einfache Weise montiert. Es wird zumindest das relativ aufwändige Handling von bisher verwendeten Schrauben vermieden. Auch ist es möglich die einzelnen Elemente der Schnappverbindung - vor dem Anbringen des Modulhalters an dem Kühlkörper - in den Modulhalter einzusetzen und diesen gemeinsam in einem Schritt an dem Kühlkörper zu befestigen. Somit wird der Montageaufwand deutlich verringert, wobei sichergestellt ist, dass eine ausreichende Befestigungskraft und Vibrationsfestigkeit gewährleistet sind.

Die Schnappverbindung ist durch ein stoffeinteilig mit dem Modulhalter ausgebildetes, eine Schnapphakenkontur ausbildendes erstes Formschlusselement und durch ein separat zu dem Modulhalter ausgeformtes zweites Formschlusselement mit umgesetzt.

Weitere vorteilhafte Ausführungen sind mit den Unteransprüchen beansprucht und nachfolgend näher erläutert.

Das erste Formschlusselement der Schnappverbindung, das stoffeinteilig mit dem Modulhalter ausgeformt ist, ist mit Aufnahmelöchern in dem Kühlkörper verrastet / verschnappt. Durch die stoffeinteilige Ausbildung wird der Montageaufwand weiter verringert.

Das zweite Formschlusselement der Schnappverbindung, das separat zu dem Modulhalter ausgeformt ist, ist formschlüssig an dem Modulhalter sowie dem Kühlkörper aufgenommen. Das vorzugsweise hülsenförmige Rastelement wird entsprechend mit Aufnahmelöchern in den Modulhalter sowie dem Kühlkörper verrastet. Dadurch ergibt sich eine besonders kostengünstig herstellbare Schnappverbindung.

Zudem ist es zweckmäßig, wenn das zweite Formschlusselement durch ein Sicherungselement vor einem Lösen der Schnappverbindung gesichert ist. Dadurch wird eine möglichst robuste Ausbildung der Leistungselektronikeinheit erzielt.

Ist eine Leiterplatine direkt an dem Modulhalter befestigt, ergibt sich eine möglichst direkte Zuordnung der Leiterplatine relativ zu den Halbleitermodulen. Relativbewegungen zwischen der Leiterplatine und den Halbleitermodulen werden weitestgehend reduziert.

In diesem Zusammenhang ist es des Weiteren vorteilhaft, wenn die Leiterplatine durch separat zu dem Modulhalter und der Leiterplatine ausgebildete Befestigungselemente, vorzugsweise durch selbstschneidende Schrauben, angebracht ist und/oder durch stoffeinteilig mit dem Modulhalter ausgeformte Befestigungselemente an dem Modulhalter angebracht ist. Die stoffeinteilig ausgebildeten Befestigungselemente sind vorzugsweise als Kunststoffvorsprünge umgesetzt, die ein Durchgangsloch in der Leiterplatine durchdringen und zu einem freien Ende hin eine Materialumformung (im Sinne einer Vernietung) aufweisen. Dadurch wird der Herstellaufwand weiter reduziert.

Ist die Leiterplatine auf einer dem zumindest einen Halbleitermodul abgewandten Seite des plattenförmigen Modulhalters an diesem angebracht, wird ein noch kompakterer Aufbau der Leistungselektronikeinheit erreicht.

Des Weiteren ist es für eine Steifigkeitserhöhung des Modulhalters zweckmäßig, wenn dieser mit Versteifungsrippen ausgeformt ist.

In diesem Zusammenhang ist es zweckdienlich, wenn der Modulhalter aus einem faserverstärkten, etwa einem glasfaserverstärkten, Kunststoff ausgeformt ist. Dadurch ist es möglich, den Modulhalter hinsichtlich der Vibrationsbeständigkeit an die Steifigkeitsvorgaben definiert anzupassen.

In anderen Worten ausgedrückt, ist erfindungsgemäß eine Anbindung von mehreren Halbleitermodulen mittels einer Kunststoffhalterung (Modulhalter) realisiert. Die Leistungshalbleitervorrichtungen (Halbleitermodule) sind an eine Wärmesenke (Kühlkörper), unter der Verwendung des Halters (Modulhalter), der aus einem Kunststoffmaterial hergestellt ist, mittels einer Schnappverbindung angebracht. Die Schnappverbindung kann durch separate Elemente oder integral mit dem Halter ausgebildet sein. Vorzugsweise ist ein unbeabsichtigtes Lösen der Schnappverbindung durch ein Befestigungselement (Verriegelungsstift / Sicherungsstift) vermieden.

Die Erfindung wird nun nachfolgend anhand von Figuren näher erläutert, in welchem Zusammenhang auch verschiedene Ausführungsbeispiele beschrieben sind.

Es zeigen:
- Fig. 1: eine perspektivische Ansicht einer erfindungsgemäßen Leistungselektronikeinheit, ausgebildet nach einem ersten Ausführungsbeispiel,
- Fig. 2: eine perspektivische Explosionsdarstellung der Leistungselektronikeinheit nach Fig. 1, wobei mehrere an einem Kühlkörper über einen Modulhalter befestigte Halbleitermodule gut zu erkennen sind,
- Fig. 3: eine weitere perspektivische Darstellung der Leistungselektronik, wobei eine auf dem Modulhalter fixierte Leiterplatine transparent dargestellt ist,
- Fig. 4: eine alleinige perspektivische Darstellung des in den Fign. 1 bis 3 eingesetzten Modulhalters von einer der Leiterplatine zugewandten Seite,
- Fig. 5: eine Seitendarstellung des Modulhalters nach Fig. 4,
- Fig. 6: eine Ansicht von einer Unterseite des Modulhalters nach den Fign. 4 und 5,
- Fig. 7: eine perspektivische Ansicht der Unterseite nach Fig. 6,
- Fig. 8: eine perspektivische Detailansicht des Modulhalters nach den Fign. 4 bis 7 mit einem in einem Aufnahmeloch des Modulhalters anzubringenden Formschlusselement, wobei das Formschlusselement über ein Sicherungselement in der fertig montierten Stellung vor einem wieder Lösen der Schnappverbindung mit dem Kühlkörper gesichert ist,
- Fig. 9: eine perspektivische Darstellung eines gemäß einem zweiten erfindungsgemäßen Ausführungsbeispiel ausgebildeten Modulhalters, der sich hinsichtlich der Ausbildung mehrerer Formschlusselemente von dem ersten Ausführungsbeispiel unterscheidet, sowie
- Fig. 10: eine Darstellung einer Unterseite des Modulhalters nach Fig. 9.

Die Figuren sind lediglich schematischer Natur und dienen ausschließlich dem Verständnis der Erfindung. Die gleichen Elemente sind mit denselben Bezugszeichen versehen.

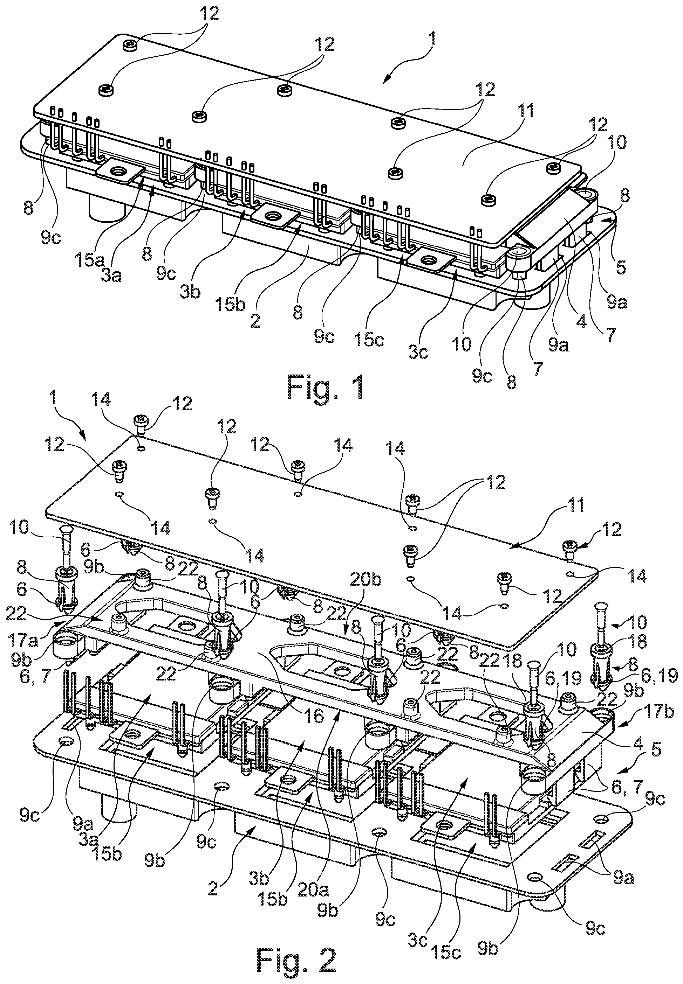

Eine in Verbindung mit den Fign. 1 bis 3 des ersten Ausführungsbeispiels gut zu erkennende erfindungsgemäße Leistungselektronikeinheit 1 ist zum Einsatz in / an einem elektrischen Antriebsmotor, d. h. in einem für einen Antrieb eines Kraftfahrzeuges eingesetzten Elektromotor, ausgebildet. Die Leistungselektronikeinheit 1 ist im Bereich einer Umrichtereinheit dargestellt. Die Leistungselektronikeinheit 1 weist folglich mehrere Halbleitermodule 3a, 3b, 3c aus, die die vom Bordnetz zur Verfügung gestellte Spannung zum Antrieb des Elektromotors bzw. eine durch den Elektromotor selbst erzeugte Spannung in eine Spannung des Bordnetzes umwandeln.

Die Leistungselektronikeinheit 1 weist einen in Fig. 2 gut zu erkennenden plattenförmigen Kühlkörper 2 auf. Der Kühlkörper 2 ist im Betrieb zur Ausbildung einer Wärmesenke auf typische Weise mit einer Kühleinrichtung verbunden und von einem Kühlmedium durchströmt. Zu einer Seite des Kühlkörpers 2 hin sind mehrere Aufnahmebereiche 15a bis 15c an dem Kühlkörper 2 vorgesehen, um mehrere Halbleitermodule 3a bis 3c aufzunehmen. Der Kühlkörper 2 weist einen ersten Aufnahmebereich 15a für ein erstes Halbleitermodul 3a auf. Dieser erste Aufnahmebereich 15a ist im Wesentlichen als eine Mulde in dem Kühlkörper 2 gebildet, in die das erste Halbleitermodul 3a eingelegt ist. Die beiden weiteren Aufnahmebereiche 15b und 15c sind zusammen mit dem ersten Aufnahmebereich 15a entlang des rechteckförmigen Kühlkörpers 2 aneinander aufgereiht angeordnet. Die beiden weiteren Aufnahmebereiche 15b und 15c sind im Wesentlichen gemäß dem ersten Aufnahmebereich 15a ausgeformt. In einem zweiten Aufnahmebereich 15b ist ein zweites Halbleitermodul 3b, in einem dritten Aufnahmebereich 15c ein drittes Halbleitermodul 3c eingelegt.

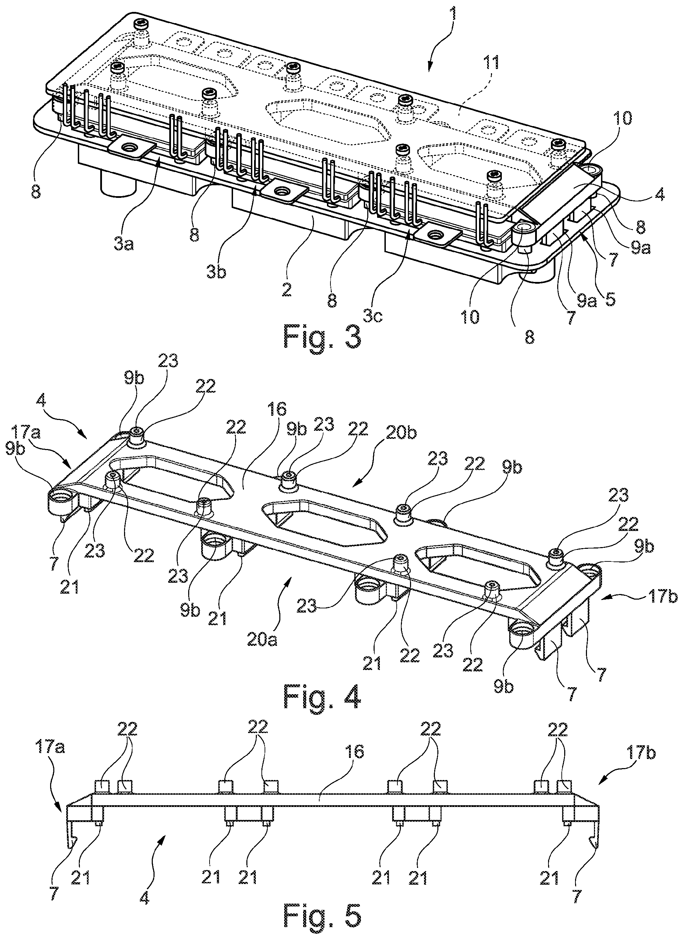

Zur letztendlich positionsgenauen Fixierung der Halbleitermodule 3a, 3b, 3c an dem Kühlkörper 2 ist ein als Modulhalter 4 bezeichneter Halter eingesetzt. Der Modulhalter 4 ist aus einem Kunststoff, nämlich aus einem faserverstärkten Kunststoff, hergestellt. Dieser Modulhalter 4, wie er alleine in Verbindung mit den Fign. 4 bis 7 dargestellt ist, ist im Wesentlichen plattenförmig realisiert. Der Modulhalter 4 ist erfindungsgemäß durch eine formschlüssige Schnappverbindung 5 im letztendlich montierten Zustand seitens des Kühlkörpers 2, unter Festlegung der einzelnen Halbleitermodule 3a, 3b, 3c an dem Kühlkörper 2, fixiert (Fign. 1 und 3). Aus Fig. 3 ist zudem ersichtlich, dass die einzelnen Halbleitermodule 3a, 3b, 3c in der fertig montierten Stellung der Leistungselektronikeinheit 1 zwischen einem Plattenbereich 16 des Modulhalters 4 und dem Kühlkörper 2 gehalten sind. Durch die Aufnahme innerhalb der Aufnahmebereiche 15a, 15b sind die Halbleitermodule 3a, 3b, 3c gleichzeitig vor einem Herausrutschen seitlich des Modulhalters 4 gesichert.

In dieser Ausführung weist der Modulhalter 4 zur Umsetzung der Schnappverbindung 5 sowohl mehrere erste Formschlusselemente 7 als auch mehrere zweite Formschlusselemente 8 auf. Die ersten Formschlusselemente 7, wie sie in Verbindung mit den Fign. 4 bis 7 zu erkennen sind, sind mit dem Modulhalter 4 stoffeinteilig ausgebildet. Die ersten Formschlusselemente 7 sind daher ebenfalls aus dem Kunststoff des Modulhalters 4 ausgeformt. Die ersten Formschlusselemente 7 sind als Schnapphaken realisiert. Zu einem ersten axialen Endbereich 17a sind zwei erste Formschlusselemente 7 an dem Modulhalter 4 vorgesehen; zu einem, dem ersten axialen Endbereich 17a entgegengesetzten, zweiten axialen Endbereich 17b sind zwei weitere erste Formschlusselemente 7 vorgesehen. Die ersten Formschlusselemente 7 werden hinter ersten Aufnahmelöchern 9a des Kühlkörpers 2, welche ersten Aufnahmelöcher 9a in Form von Langlöchern realisiert sind, unter Ausbildung der Schnappverbindung 5 verrastet.

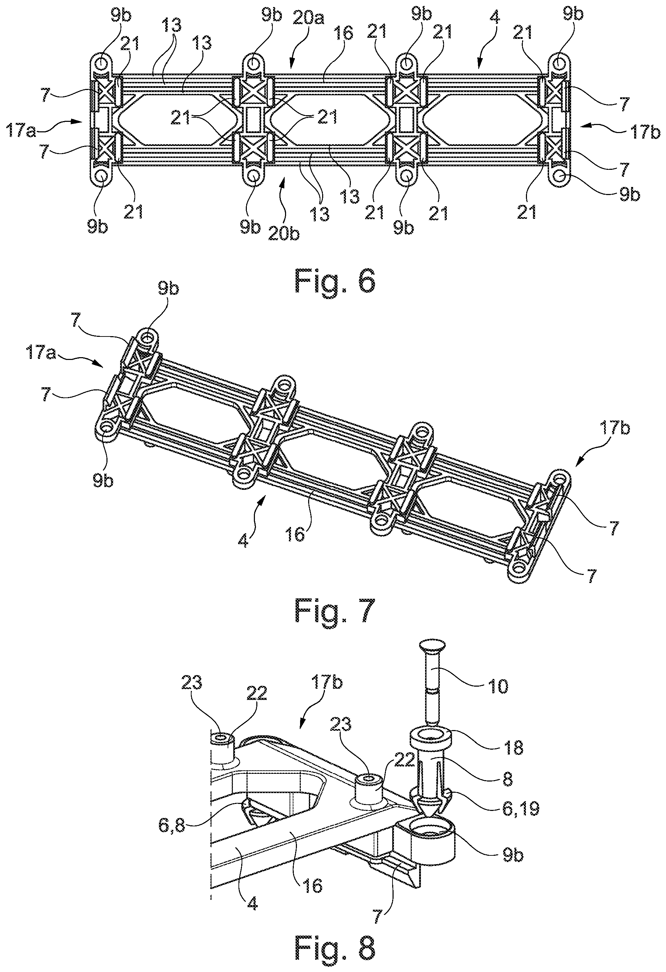

Zudem sind mehrere zweite Formschlusselemente 8 vorgesehen. Diese zweiten Formschlusselemente 8, wie detailliert in Fig. 8 zu erkennen, sind separat zu dem Modulhalter 4 ausgebildet und im Wesentlichen hülsenförmig umgesetzt. Jedes zweite Formschlusselement 8 weist zu einem ersten Ende hin einen Bund 18 und zu einem zweiten Ende mehrere Schnappnasen 19 auf. Während die Schnappnasen 19 wiederum eine Schnapphakenkontur 6 ausbilden und in der fertig montierten Stellung, unter Ausbildung der Schnappverbindung 5, hinter einem (dritten) Aufnahmeloch 9c des Kühlkörpers 2 verrastet sind, liegt der Bund 18 flächig an dem Modulhalter 4 auf. Der Modulhalter 4 ist zum Aufnehmen der zweiten Formschlusselemente 8 mit mehreren zweiten Aufnahmelöchern 9b versehen. Jedes zweite Formschlusselement 8 ist mit einem Sicherungselement 10, das einen Sicherungsstift bildet, in seiner verrasteten Position gesichert. Hierzu ist das Sicherungselement 10 in ein zentrales Loch des zweiten Formschlusselementes 8 eingeschoben und hindert die Schnappnasen 19 vor einem erneuten Zurückfedern und somit vor einem Lösen der Schnappverbindung 5.

Insgesamt sind je Längsseite 20a, 20b des Modulhalters 4 vier zweite Formschlusselemente 8 vorgesehen, wobei die Formschlusselemente 8 einer Längsseite 20a, 20b nebeneinander aufgereiht angeordnet sind. Insbesondere ist je Längsseite 20a, 20b ein zweites Formschlusselement 8 zu dem ersten Endbereich 17a hin angeordnet, ein weiteres zweites Formschlusselement 8 zu dem zweiten Endbereich 17b angeordnet und zwei weitere zweite Formschlusselemente 8 zwischen dem ersten Halbleitermodul 3a und dem zweiten Halbleitermodul 3b bzw. dem zweiten Halbleitermodul 3b und dem dritten Halbleitermodul 3c angeordnet. Im Bereich zwischen den Halbleitermodulen 3a, 3b, 3c sind zudem Stützstege 21 an dem Modulhalter 4 vorgesehen, die flächig an dem Kühlkörper 2, im Bereich zwischen den Halbleitermodulen 3a, 3b, 3c, anliegen.

In Verbindung mit den Fign. 6 und 7 ist gut zu erkennen, dass auf einer dem Kühlkörper 2 zugewandten Seite des Modulhalters 4 auf typische Weise mehrere Versteifungsrippen 13 vorgesehen sind. Diese Versteifungsrippen 13 verlaufen im Wesentlichen in Längsrichtung des Modulhalters 4 und parallel zueinander.

Des Weiteren ist eine Leiterplatine 11 unmittelbar über mehrere Befestigungselemente 12 an dem Modulhalter 4 fixiert. Die als Gate-Leiterplatine umgesetzte Leiterplatine 11 ist auf einer dem Kühlkörper 2 abgewandten Seite des Modulhalters 4 angeordnet. Die Befestigungselemente 12 sind als selbstschneidende Schrauben realisiert. Jedes Befestigungselement 12 durchdringt ein Durchgangsloch 14 in der Leiterplatine 11 und ist an einem stoffeinteilig ausgebildeten Sockel 22 des Modulhalters 4 verschraubt. Der Sockel 22 weist hierzu vorzugsweise bereits ein Loch 23 auf, das kleiner als ein Durchmesser (Schraubengewindedurchmesser) des Befestigungselementes 12 ist.

In diesem Zusammenhang sei prinzipiell darauf hingewiesen, dass die Befestigungselemente 12 auch auf andere Weise umsetzbar sind. Gemäß einer weiter bevorzugten Ausführung, die hier der Übersichtlichkeit halber nicht weiter dargestellt ist, sind die Sockel 22 selbst unmittelbar als Befestigungselemente umgesetzt. Gemäß dieser weiteren Ausführung ist jedes in der Leiterplatine 11 eingebrachte Durchgangsloch 14 größer als der jeweilige Sockel 22 gewählt und über diesen Sockel 22 aufgeschoben, sodass der Sockel 22 die Leiterplatine 11 durchdringt. Ein durch die Leiterplatte 11 hindurchragender, ein freies Ende bildender Bereich des Sockels 22 wird im Anschluss derart (vorzugsweise thermisch) umgeformt, dass dieses freie Ende eine die Leiterplatine 11 hintergreifende Form, etwa eine Pilzform, ausbildet und dadurch die Leiterplatine 11 relativ zu dem Modulleiter 4 festhält.

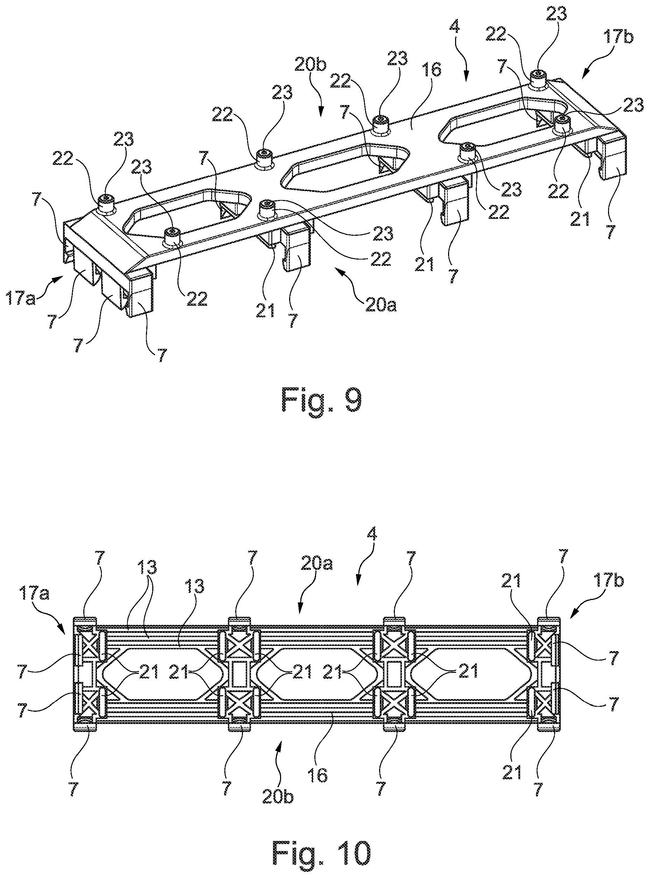

In Verbindung mit den Fign. 9 und 10 ist auf ein alternative, nicht erfindungsgemäße Ausgestaltung hingewiesen. In dieser Ausgestaltung ist der übrige Aufbau der Leistungselektronik 1 gemäß dem ersten Ausführungsbeispiel ausgeführt, weshalb nachfolgend lediglich auf die Unterschiede in der Ausformung des Modulhalters 4 eingegangen wird. Wie in Verbindung mit den Fign. 9 und 10 zu erkennen, wird nun auf die zweiten Formschlusselemente 8 verzichtet. Die bisher in dem ersten Ausführungsbeispiel die zweiten Aufnahmelöcher 9b aufweisenden Bereiche des Modulhalters 4 sind durch erste Formschlusselemente 7, die als Schnapphaken realisiert sind, ersetzt. Somit sind auch an den beiden Längsseiten 20a und 20b des Modulhalters 4 mehrere, nämlich vier, erste Formschlusselemente 7 vorgesehen, die jeweils mit einem hier der Übersichtlichkeit halber nicht weiter dargestellten dritten Aufnahmeloch 9c an dem Kühlkörper 2 verrastet sind.

In anderen Worten ausgedrückt, werden erfindungsgemäß Leistungshalbleiter (Halbleitermodule 3a, 3b, 3c) mit einem Halter 4 aus Kunststoff mit Hilfe von Schnapphaken 6; 7 an den Kühlkörper 2 angebunden. Die Schnapphaken 6; 7 werden zusätzlich mit Sicherungselementen 10 gegen ein unbeabsichtigtes Öffnen gesichert. Die Konstruktion ermöglicht einen möglichst kompakten Aufbau des Umrichters 1. Durch die Integration von Modulhalter 4 und Gatetreiber-Platine 11 können Bauteile eingespart werden. Da der Gatetreiber 11 und die Leistungsmodule (Halbleitermodule 3a, 3b, 3c) beide mit dem Leistungsmodulhalter 4 montiert sind, können Relativbewegungen an den Hilfskontakten durch etwa Vibration vermindert werden. Diese Relativbewegungen sind kritisch für die Lebensdauer der elektrischen Kontakte. Die Schnapphaken 6; 7 ermöglichen eine einfache und kostengünstige Montage. Bisherige Verschraubprozesse, die drehmomentüberwacht werden müssen, und das Handling der Schrauben entfällt. Bei Kühlkörpern 2 aus Kunststoff mussten demnach Gewindeinserts eingebracht werden bevor die Leistungsmodule 3a, 3b, 3c verschraubt werden konnten. Diese Anforderungen an den Kühlkörperwerkstoff entfallen mit den Schnapphaken 6, 7. Aufgrund der Kunststoffkonstruktion des Modulhalters 4 lassen sich mit der Auslegung der Verrippungen 13 und durch das Einstellen des Elastizitätsmoduls des verwendeten Kunststoffs durch Füllstoffe, wie durch Glasfasern, effektive Maßnahmen zur Versteifung und Dämpfung von Vibrationsanregungen in speziellen Frequenzbereichen realisieren. Die Gatetreiber Platine 11 kann mit selbst schneidenden Schrauben 12 an dem Modulhalter 4 befestigt sein. Die Kräfte an der Platine 11 sind hierbei so gering, dass Gewindeinserts nicht notwendig sind. Dank des Kunststoff-Modulträgers 4 kann auch das Heißverstemmen als Befestigungsverfahren für die Gatetreiber-Platine 11 eingesetzt werden. Dazu werden anstelle der Löcher 23 für die Schrauben 12 Zapfen (Sockel 22) an dem Modulhalter 4 gespritzt. Auf diese wir die Platine 11 an den Befestigungslöchern 14 aufgefädelt und mit einem warmen Stempel der überstehende Zapfen 22 pilzförmig umgeformt (ähnlich einer Nietverbindung).

### Bezugszeichenliste

- 1: Leistungselektronikeinheit
- 2: Kühlkörper
- 3a: erstes Halbleitermodul
- 3b: zweites Halbleitermodul
- 3c: drittes Halbleitermodul
- 4: Modulhalter
- 5: Schnappverbindung
- 6: Schnapphakenkontur
- 7: erstes Formschlusselement
- 8: zweites Formschlusselement
- 9a: erstes Aufnahmeloch
- 9b: zweites Aufnahmeloch
- 9c: drittes Aufnahmeloch
- 10: Sicherungselement
- 11: Leiterplatine
- 12: Befestigungselement
- 13: Versteifungsrippe
- 14: Durchgangsloch
- 15a: erster Aufnahmebereich
- 15b: zweiter Aufnahmebereich
- 15c: dritter Aufnahmebereich
- 16: Plattenbereich
- 17a: erster Endbereich
- 17b: zweiter Endbereich
- 18: Bund
- 19: Schnappnase
- 20a: erste Längsseite
- 20b: zweite Längsseite
- 21: Stützsteg
- 22: Sockel

## Patentansprüche

1. Leistungselektronikeinheit (1) für einen Elektromotor eines Kraftfahrzeugantriebs, mit:
einem plattenförmigen Kühlkörper (2),
zumindest einem Halbleitermodul (3a, 3b, 3c) und
einem aus einem Kunststoff bestehenden, das zumindest eine Halbleitermodul (3a, 3b, 3c) relativ zu dem Kühlkörper (2) festlegenden Modulhalter (4), wobei
der Modulhalter (4) über eine formschlüssige Schnappverbindung (5) an dem Kühlkörper (2) fixiert ist, und
die Schnappverbindung (5) durch ein stoffeinteilig mit dem Modulhalter (4) ausgebildetes, eine Schnapphakenkontur ausbildendes erstes Formschlusselement (7) umgesetzt ist,
**dadurch gekennzeichnet, dass**
die Schnappverbindung zusätzlich durch ein separat zu dem Modulhalter (4) ausgeformtes zweites Formschlusselement (8) umgesetzt ist,
das erste Formschlusselement (7) der Schnappverbindung (5) mit Aufnahmelöchern (9a; 9c) in dem Kühlkörper (2) verrastet ist, und
das zweite Formschlusselement (8) der Schnappverbindung (5) formschlüssig an dem Modulhalter (4) und dem Kühlkörper (2) aufgenommen ist.

2. Leistungselektronikeinheit (1) nach Anspruch 1, **dadurch gekennzeichnet, dass** das das zweite Formschlusselement (8) durch ein Sicherungselement (10) vor einem Lösen der Schnappverbindung (5) gesichert ist.

3. Leistungselektronikeinheit (1) nach Anspruch 1 oder 2, **dadurch gekennzeichnet, dass** eine Leiterplatine (11) direkt an dem Modulhalter (4) befestigt ist.

4. Leistungselektronikeinheit (1) nach Anspruch 3, **dadurch gekennzeichnet, dass** die Leiterplatine (11) durch separat zu dem Modulhalter (4) und der Leiterplatine (11) ausgebildete Befestigungselemente (12) und/oder durch stoffeinteilig mit dem Modulhalter (4) ausgeformte Befestigungselemente an dem Modulhalter (4) angebracht ist.

5. Leistungselektronikeinheit (1) nach Anspruch 3 oder 4, **dadurch gekennzeichnet, dass** die Leiterplatine (11) auf einer dem zumindest einen Halbleitermodul (3a, 3b, 3c) abgewandten Seite des plattenförmigen Modulhalters (4) an diesem angebracht ist.

6. Leistungselektronikeinheit (1) nach einem der Ansprüche 1 bis 5, **dadurch gekennzeichnet, dass** der Modulhalter (4) mit mehreren Versteifungsrippen (13) ausgeformt ist.

7. Leistungselektronikeinheit (1) nach einem der Ansprüche 1 bis 6, **dadurch gekennzeichnet, dass** der Modulhalter (4) aus einem faserverstärkten Kunststoff ausgeformt ist.

## Claims

1. A power electronics unit (1) for an electric motor of a motor vehicle drive, having:
a plate-shaped heat sink (2),
at least one semiconductor module (3a, 3b, 3c) and
a module holder (4) made of a plastic material and fixing at least one semiconductor module (3a, 3b, 3c) relative to the heat sink (2), wherein
the module holder (4) is fixed to the heat sink (2) via a form-fitting snap connection (5), and
the snap connection (5) is implemented by a first form-fitting element (7) formed integrally with the module holder (4) and forms a snap-hook contour,
**characterised in that**
the snap connection is additionally implemented by a second form-fitting element (8) formed separately from the module holder (4),
the first form-fitting element (7) of the snap connection (5) is locked with receiving holes (9a; 9c) in the heat sink (2), and
the second form-fitting element (8) of the snap connection (5) is form-fittingly received on the module holder (4) and the heat sink (2).

2. The power electronics unit (1) according to claim 1, **characterised in that** the second form-fitting element (8) is secured against release of the snap connection (5) by a securing element (10).

3. The power electronics (1) according to claim 1 or 2, **characterised in that** a printed circuit board (11) is fastened directly to the module holder (4).

4. The power electronics unit (1) according to claim 3, **characterised in that** the printed circuit board (11) is attached to the module holder (4) by fastening elements (12) formed separately from the module holder (4) and the printed circuit board (11) and/or by fastening elements formed integrally with the module holder (4).

5. The power electronics unit (1) according to claim 3 or 4, **characterised in that** the printed circuit board (11) is attached to the plate-shaped module holder (4) on a side facing away from the at least one semiconductor module (3a, 3b, 3c).

6. The power electronics unit (1) according to one of claims 1 to 5, **characterised in that** the module holder (4) is formed with a plurality of reinforcing ribs (13).

7. The power electronics unit (1) according to one of claims 1 to 6, **characterised in that** the module holder (4) is formed from fibre-reinforced plastic.

## Revendications

1. Unité d'électronique de puissance (1) pour un moteur électrique d'un entraînement de véhicule automobile, comportant :
un dissipateur thermique en forme de plaque (2),
au moins un module semi-conducteur (3a, 3b, 3c) et
un support de module (4) constitué d'une matière synthétique fixant l'au moins un module semi-conducteur (3a, 3b, 3c) par rapport au dissipateur thermique (2),
le support de module (4) étant fixé au dissipateur thermique (2) par l'intermédiaire d'une liaison à encliquetage (5) par ajustement de forme, et
la liaison à encliquetage (5) étant réalisée par un premier élément d'ajustement de forme (7) qui est formé d'un seul tenant avec le support de module (4) et qui forme un contour de crochet d'encliquetage,
**caractérisée en ce que**
la liaison à encliquetage est en outre réalisée par un second élément d'ajustement de forme (8) formé séparément du support de module (4),
le premier élément d'ajustement de forme (7) de la liaison à encliquetage (5) est encliqueté avec des trous de réception (9a ; 9c) dans le dissipateur thermique (2), et
le second élément d'ajustement de forme (8) de la liaison à encliquetage (5) est reçu par ajustement de forme sur le support de module (4) et le dissipateur thermique (2).

2. Unité d'électronique de puissance (1) selon la revendication 1, **caractérisée en ce que** que le second élément d'ajustement de forme (8) est sécurisé par un élément de sécurisation (10) contre toute libération de la liaison à encliquetage (5).

3. Unité d'électronique de puissance (1) selon la revendication 1 ou 2, **caractérisée en ce qu'**une carte de circuit imprimé (11) est fixée directement au support de module (4).

4. Unité d'électronique de puissance (1) selon la revendication 3, **caractérisée en ce que** la carte de circuit imprimé (11) est montée sur le support de module (4) par des éléments de fixation (12) formés séparément du support de module (4) et de la carte de circuit imprimé (11) et/ou par des éléments de fixation formés d'un seul tenant avec le support de module (4).

5. Unité d'électronique de puissance (1) selon la revendication 3 ou 4, **caractérisée en ce que** la carte de circuit imprimé (11) est montée sur le support de module (4) en forme de plaque sur un de ses côtés opposé à l'au moins un module semi-conducteur (3a, 3b, 3c).

6. Unité d'électronique de puissance (1) selon l'une des revendications 1 à 5, **caractérisée en ce que** le support de module (4) est formé avec plusieurs nervures de raidissement (13).

7. Unité d'électronique de puissance (1) selon l'une des revendications 1 à 6, **caractérisée en ce que** le support de module (4) est formé à partir d'une matière synthétique renforcée par des fibres.
